# EUROPEAN PATENT APPLICATION

(11) **EP 2 160 083 A1**
(43) Date of publication of application: **03.03.2010**
(21) Application number: 09252100.4
(22) Date of filing: 28.08.2009
(51) Int. Cl.: H05K 5/00, H01H 9/02, H02B 1/42, H02G 3/12

(54) **Frame for supporting keypad and other in-wall electronic components**

(30) Priority: 29.08.2008 US 190521 P
(71) Applicant: Russound/FMP Incorporated, Newmarket, NH 03857 (US)
(72) Inventor: Stein, Michael, Amesbury, MA 01913 (US)
(74) Representative: Charig, Raymond Julian

(57) **Abstract**

A multi-part electrical/electronics enclosure that may be used for in-wall installation of intercom, home audio, lighting and other similar system components. The enclosure includes two major components including aback box and a frame. The frame acts as a structural member for both, electronic components internal to the back box as well as user-facing input/output electronic devices such as a keypad and/or display. The frame is preferably formed from aluminum to act as a heat sink, and has front facing standoffs. The standoffs ensure an air gap is maintained between the frame and a front bezel, to allow for airflow and hence cooling by convection.

## Description

### RELATED APPLICATION(S)

This application claims the benefit of U.S. Provisional Application No. 61/190,521, filed on August 29, 2008. The entire teachings of the above application are incorporated herein by reference.

### BACKGROUND OF THE INVENTION

Systems for automated distribution of entertainment media, control of lighting, intercom, security, and multi-room audio-visual systems are becoming more and more desirable in both homes and businesses. These systems typically involve some sort of control unit placed on or within a wall. The control unit may typically serve to enclose electronics and is connected to a source of electric power, such as an Alternating Current (AC) main.

### SUMMARY OF THE INVENTION

The present invention relates to an in-wall enclosure having a frame portion that serves both as a support and a heat sink for electronic circuitry, as well as a mounting location for an associated keypad and facia portion of the control unit.

In one preferred embodiment, a multi-piece electrical/electronics enclosure may be used for in-wall installation of keypads, controllers and similar devices as part of an intercom, home audio, interior lighting or similar systems. The enclosure includes at least two major components including a back box serving to house low voltage electronics, and a frame that fits into the back box. The frame acts as both a heat sink and structural member for various electronic components, both internal to the enclosure and external, or user-facing.

The frame may have a front face wall and two side walls that extend inwardly from the front face wall. The outward side of the face serves as a mounting location and/or substrate for a display, keypad, or other user-facing electronics. An inward side of the face wall, as well as the two side walls, serve as a substrate for the internal electronic components.

Optionally, the face wall may include spacers or standoffs so that an air gap is maintained between the front face and a facia or bezel. This permits air to flow around the frame, such as by convection.

The arrangement provides ease in assembly of the enclosure in the field by an audio equipment systems integrator, for example.

### BRIEF DESCRIPTION OF THE DRAWINGS

The foregoing will be apparent from the following more particular description of example embodiments of the invention, as illustrated in the accompanying drawings in which like reference characters refer to the same parts throughout the different views. The drawings are not necessarily to scale, emphasis instead being placed upon illustrating embodiments of the present invention.
Fig. 1 is an isometric view of an in-wall enclosure according to certain aspects of the invention, showing the frame with a key pad removed.
Fig. 2 is an exploded view of the components of the enclosure and key pad.
Fig. 3 is a more detailed view of a frame.
Fig. 4 is a front view of a keypad assembly.
Fig. 5 is a top perspective view of a completed keypad and frame before it is inserted into the back box.
Fig. 6 is a more detailed view of the completed keypad inserted into back box.
Fig. 7 is a side view of how a facia is attached to the frame.
Fig. 8 is a more detailed view of a bezel and how it attaches to the frame.

### DETAILED DESCRIPTION OF THE INVENTION

A description of example embodiments of the invention follows.

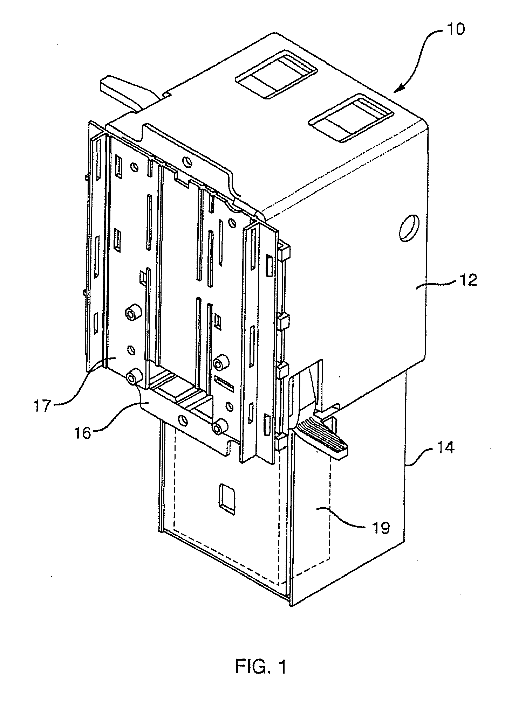

Fig. 1 shows an electrical/electronics enclosure assembly 10 that embodies one or more aspects of the present invention. Enclosure assembly 10 includes a back box 12 and a frame 17, the frame 17 shown here without a front facia or keypad installed. An optional power pocket 14, trade separator 16, and power supply sub-housing 19 are also shown as parts of this particular enclosure assembly 10. The assembly 10 can be used as an in-wall enclosure for system components that require both high voltage electrics and low voltage electronics. Such enclosures 10 can find use to house switches, buttons, keypads and other user input/output devices. These devices may control various types of equipment such as distributed multimedia, intercom, automated lighting, security and other types of systems.

The structural components of enclosure 10 may typically be formed of steel, aluminum or other suitable materials. In preferred embodiments, frame 17 is formed of aluminum or other suitable material to also serve as a heat sink for electronic components located internally to back box 12.

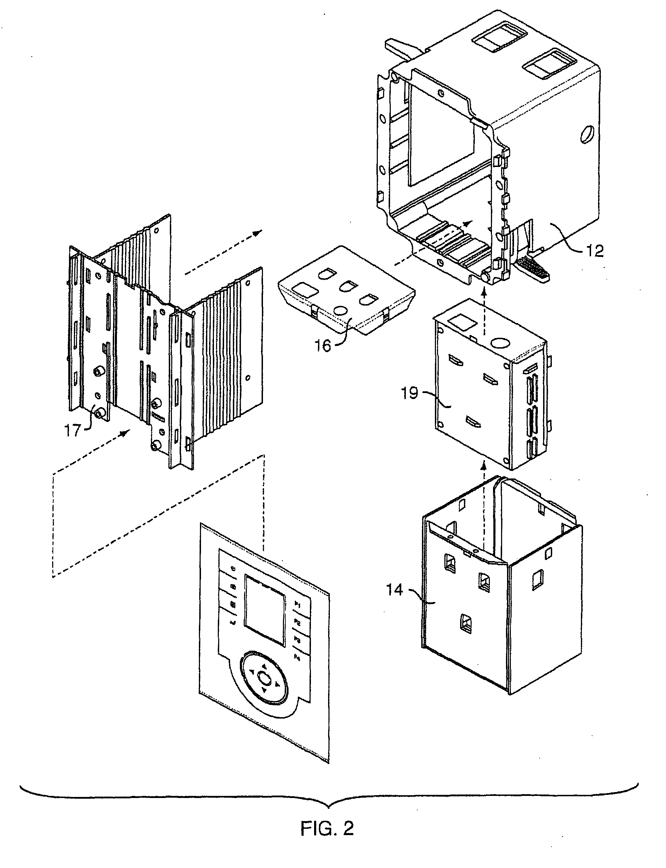

Fig. 2 is an exploded view showing these same and other components.

Back box 12 serves to enclose low voltage electronic components such as may include lighting controls, control keypads, audio amplifiers, intercom circuits, speakers, and the like. The back box 12 may also contain low voltage speaker wire termination points for external speakers or the like.

In general, the optional power pocket 14 can enclose high voltage wiring and any associated high voltage circuitry that are connected to a high voltage power source, for example, a household main 120 or 240 volt Alternating Current (AC) source. For example, power pocket 14 may enclose wiring, or even a power supply (within sub-housing 19) that converts incoming 120 volt AC to low voltage (e.g.., 5 to 10 volt) DC as needed to power the electronics.

Removable trade separator 16 allows for high voltage electrics to be completely enclosed by power pocket 14, while still allowing for easy access to the electronics inside power pocket 16 even after initial assembly, without removing back box 12 from a wall in which it may be installed.

As will be described in more detail below, frame 17 serves to both support electronic components inside back box 12 such as may include the lighting controls, audio amplifiers, intercom circuits, speakers and the like (not shown in Fig. 2) as well as a mechanical support for user accessible components such as a facia/keypad assembly 30.

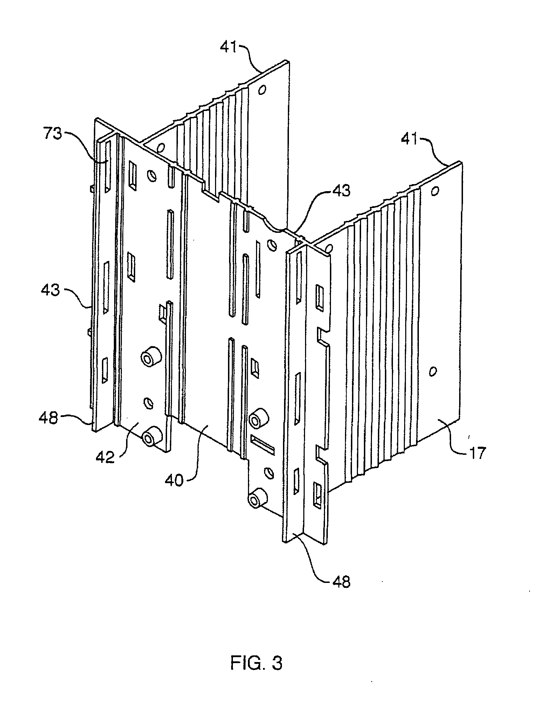

Fig. 3 shows frame 17 in more detail. Frame 17 includes at least a front face 40 and preferably two side walls 41. Side walls 41 extend inwardly from front face 40. In general, the outward facing side 42 of front face 40 serves to support a keypad and display where as the inward facing surface 43 as well as side walls 41 serve to support internal electronic components. Frame 17 slides into position inside back box 12 when assembling enclosure 10.

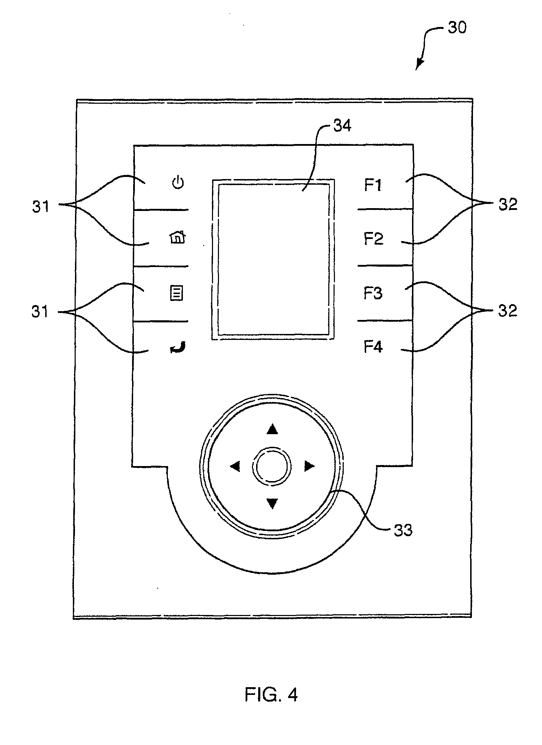

Fig. 4 is a more detailed view of a typical keypad 30. Keypad 30 may have a number of function button inputs 31, 32, a scroll wheel input 33, display 34 or other user input/output devices on a facia thereof.

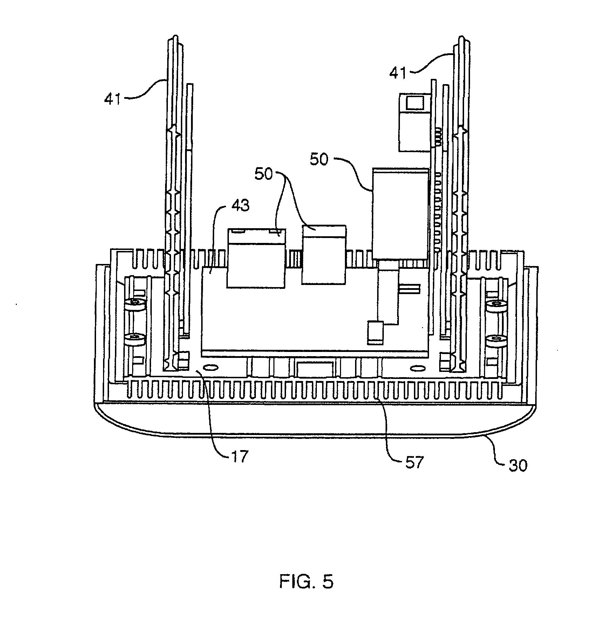

Fig. 5 is a isometric view of the assembled frame and keypad/facia 30, assembly of which may be performed at a factory. Here the facia/keypad assembly 30 has been attached to the front face of frame 17. Electronic components 50 have also been installed on side walls 41 and the interior surface 43 of front face 40. The same frame 17 serves not only as a mounting location and heat sink for electronic components 50 but also as a support, heat sink, and mounting location for components of the facia/keypad assembly 30.

Slots 57 formed in the top and bottom of facia 30 serve to allow for convection cooling. With reference to Fig. 3, it is noted that spacers 48 are preferably located on the front face 40 of frame 17. These then ensure a space is maintained between front face 40 and the back of the facia/keypad 30 for airflow by convection for example.

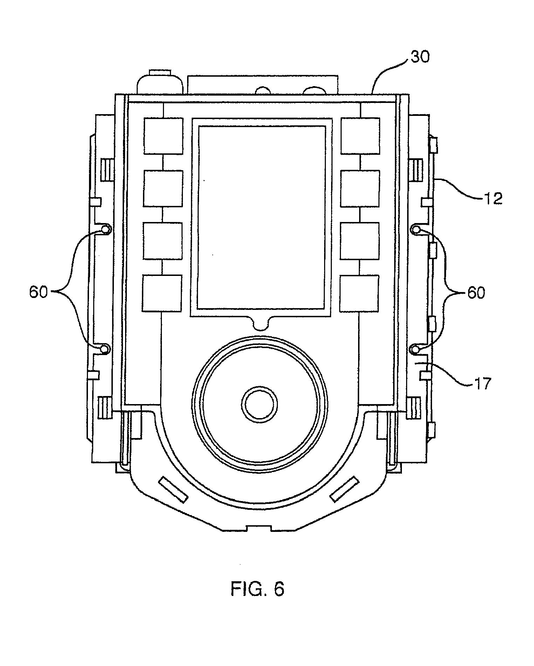

Fig. 6 is a front view of the assembled facia/keypad 30, frame 17 and back box 12. Mounting holes 60 in frame 17 provide a location for screws to hold frame 17 in place against back box 12.

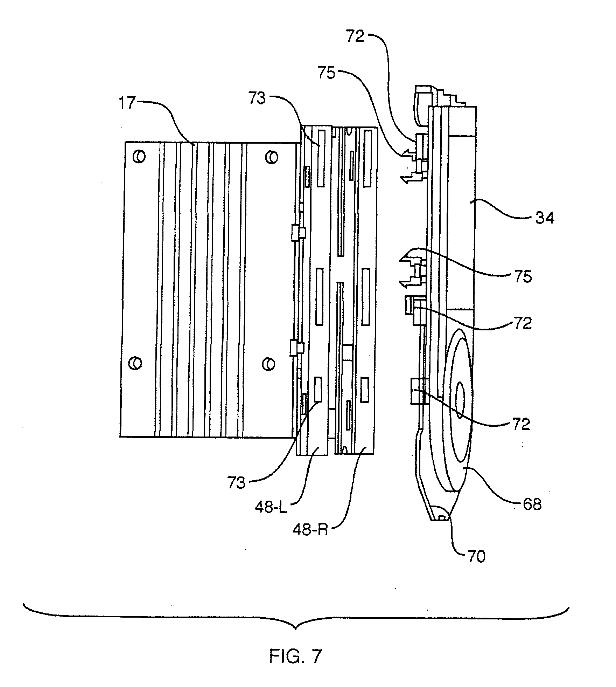

Fig. 7 is a side view illustrating that keypad/facia assembly 30 includes both a keypad sub-assembly portion 68 and facia portion 70. Facia portion 70 attaches to frame 17 by way of snaps (connectors) 72 that engage holes 73 in the side walls of standoffs 48. A carrier snap 75 may also provide additional location for mounting of electronic components which may be needed to drive display 34.

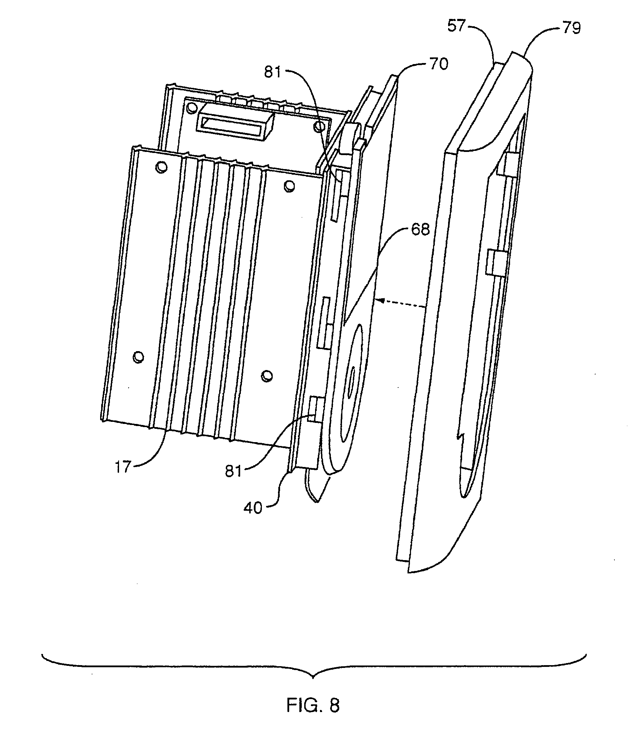

The assembly of keypad 68 and facia 70 to frame 17 typically occurs at a factory location, as mentioned above. This assembly is then placed into back box 12 at a consumer location. Finally, a bezel portion 79 as shown in Figure 8 is installed. Plastic snap portions 81 formed on the outer surface of facia 70 may be used to provide a location for attachment of bezel 79 after the assembled frame 17 is fastened, such as with screws, to back box 12.

Bezel 79 has the aforementioned holes 57 formed therein so that when the entire enclosure 10 is completely installed, an air gap remains between the keypad 68, facia 70 and/or front face 40 of frame 17. This allows air to circulate through the unit and past the front face of frame 17 via convection. Frame 17, acting as a heat sink, can then provide enhanced cooling to the components mounted thereon.

The device described above can be used to satisfy Underwriter Laboratories (UL) and/or local building codes that require high and low voltage electric and electronics to be in physically separate enclosures.

While this invention has been particularly shown and described with references to example embodiments thereof, it will be understood by those skilled in the art that various changes in form and details may be made therein without departing from the scope of the invention encompassed by the appended claims.

## Claims

1. An enclosure for electrical and electronic circuitry comprising:
a back box, adapted to fit into a wall opening, the back box for enclosing electronic components; and
a frame, adapted to fit into the back box, for supporting both the enclosed electronic components and for supporting a user device accessible from outside the back box.

2. The enclosure of claim 1 wherein the frame serves as a heat sink for the electronic components.

3. The enclosure of claim 1 wherein the frame further comprises:
a standoff portion, to maintain a space between the frame and the user input/output device.

4. The enclosure of claim 1, wherein the frame is formed of metal.

5. The enclosure of claim 1, additionally comprising a power pocket adapted to fit within an opening in the back box, the power pocket for enclosing alternating current main supply wiring.

6. The enclosure of claim 1, wherein the frame has a front face an inwardly extending side walls.

7. The enclosure of claim 1, wherein the user device is a keypad.

8. The apparatus of claim 1, wherein the user devices a display.

9. The apparatus of claim 1, additionally comprising:
a facia adapted to support the user device.

10. The apparatus of claim 9, wherein the facia includes a bezzle having holes formed therein to promote air circulation above the front face of the frame.
